# FASCICULE DE BREVET EUROPEEN

(11) **EP 4 195 905 B1**
(45) Date de publication et mention de la délivrance du brevet: **02.07.2025**
(21) Numéro de dépôt: 22211681.6
(22) Date de dépôt: 06.12.2022
(51) Int. Cl.: H10B 63/00, G11C 13/00, H10D 86/40

(54) **DISPOSITIF DE PILOTAGE DE TRANSISTORS ET PROCÉDÉ DE PILOTAGE**
TRANSISTORANSTEUERUNGSVORRICHTUNG UND ANSTEUERUNGSVERFAHREN
TRANSISTOR DRIVING DEVICE AND DRIVING METHOD

(30) Priorité: 13.12.2021 FR 2113374
(43) Date de publication de la demande: 14.06.2023
(73) Titulaire: Commissariat à l'Energie Atomique et aux Energies Alternatives, 75015 Paris (FR)
(72) Inventeur: GIRAUD, Bastien, 38054 GRENOBLE Cedex 09 (FR); ANDRIEU, François, 38054 GRENOBLE Cedex 09 (FR); MOURSY, Yasser, 38054 GRENOBLE Cedex 09 (FR)
(74) Mandataire: Hautier IP

(56) Documents cités:
- FR-A1- 2 975 828
- FR-A1- 3 003 690
- US-A1- 2019 385 677

## Description

### DOMAINE TECHNIQUE

La présente invention concerne, en général, un dispositif de pilotage comprenant une pluralité de transistors présentant un même type de conductivité, et plus particulièrement, des transistors du même type sur un substrat de type semiconducteur sur isolant totalement déplété. La présente invention concerne également un procédé de pilotage de ce dispositif de pilotage de transistors. Une application avantageuse de ce dispositif de pilotage de transistors concerne les circuits à mémoires résistives de type RRAM (acronyme anglais de «Resistive Random Access Memories » signifiant « mémoires résistives à accès aléatoire »).

### ETAT DE LA TECHNIQUE

Les mémoires résistives, en particulier les mémoires résistives de type OxRAM (acronyme anglais de « Oxide-Based Random Access Memories » signifiant « mémoires à accès aléatoire à base d'oxyde ») sont actuellement développées pour les applications non-volatiles, dans le but de remplacer les mémoires de type Flash. Elles présentent notamment pour avantage d'être intégrables avec le procédé de fin de ligne BEOL (acronyme anglais de « Back-End Of Line ») de la technologie CMOS (acronyme anglais de « Complementary Metal-Oxide-Semiconductor » signifiant technologie à base de transistors « Métal-Oxyde-Semiconducteur complémentaires »).

Les mémoires résistives comprennent typiquement une multitude de cellules mémoire agencées sous forme de matrice. Dans une configuration dite « 1T1R », chaque cellule mémoire (appelée également point mémoire) comprend un élément mémoire résistif (« 1R ») associé à un transistor de sélection (« 1T »).

L'élément mémoire résistif peut commuter de manière réversible entre deux états de résistance, qui correspondent à des valeurs logiques « 0 » et « 1 » utilisées pour coder un bit d'information.

L'information est écrite dans la cellule mémoire en basculant l'élément mémoire résistif d'un état fortement résistif (ou « HRS », pour « High Resistance State » en anglais) à un état faiblement résistif (« LRS », pour « Low Resistance State »). À l'inverse, pour effacer l'information de la cellule mémoire, l'élément mémoire résistif est basculé de l'état faiblement résistif vers l'état fortement résistif.

Dans certains cas, plus de deux états de résistance peuvent être générés, ce qui permet de stocker plusieurs bits d'information dans une même cellule mémoire. On parle alors de cellules multi-niveaux MLC (acronyme anglais de « Multi Level Cells »).

L'écriture et l'effacement de ces cellules multiniveaux MLC peuvent être réalisés en contrôlant finement, de manière analogique, la tension appliquée aux différentes connexions de la cellule mémoire. Ces connexions sont dénommées de façon connue « bitline » BL (connexion à l'élément résistif), « sourceline » SL (connexion à la source du transistor de sélection), « wordline » WL (connexion à la grille du transistor de sélection). D'autres solutions d'écriture et d'effacement connues consistent à faire varier la durée des opérations de passage dites SET/RESET (passage de HRS vers LRS/ passage de LRS vers HRS, respectivement), typiquement en ajustant la largeur des pulses en tension appliqués. Cette gestion « analogique » de l'écriture et de l'effacement nécessite néanmoins des nouveaux circuits de génération ou de régulation des tensions et courants analogiques et/ou une forte modification des circuits existants.

Par ailleurs, la taille d'une cellule mémoire 1T1R est principalement dictée par la surface du substrat occupée par le transistor de sélection, plutôt que par les dimensions de l'élément mémoire, ce dernier étant situé au niveau de la métallisation (BEOL). Pour augmenter la densité des mémoires résistives, il est donc nécessaire de réduire la surface occupée par le transistor de sélection de chaque cellule mémoire. Cette réduction s'effectue typiquement au détriment du courant que le transistor de sélection est capable de délivrer. La fenêtre de programmation de la cellule mémoire est dès lors réduite. Une solution consiste à appliquer une polarisation en face arrière du transistor (technique appelée BB pour « back-biasing » en anglais), qui permet de moduler dynamiquement la tension de seuil du transistor et donc sa capacité à fournir du courant. Une polarisation arrière directe (ou FBB, pour « Forward Back-Bias » en anglais) du transistor de sélection permet généralement de diminuer la tension de seuil et d'augmenter le courant passant, par exemple lors d'une opération d'écriture des cellules mémoire. Une polarisation arrière inverse (ou RBB, pour « Reverse Back-Bias » en anglais) du transistor de sélection permet typiquement de limiter les fuites de courant, par exemple lors d'une opération de lecture des cellules mémoire. Différentes architectures mettant en œuvre une polarisation BB ont été développées. Le document « Truly Innovative 28nm FDSOI Technology for Automotive Micro-Controller Applications embedding 16MB Phase Change Memory, F. Arnaud et al, IEDM18-424 (2018) » décrit une architecture de cellules mémoire à base de transistors complémentaires sur un substrat de type silicium sur isolant totalement déplété FDSOI (acronyme de « Fully Depleted Silicon On Insulator »). La mise en œuvre de la polarisation BB reste limitée et en partie inefficace dans ce type d'architecture. Les cellules mémoire présentent en particulier des performances inhomogènes avec ce type d'architecture. Le document FR2975828 A1 divulgue une autre architecture de pilotage de transistors NMOS et PMOS nécessitant un plan de masse intercalé entre la couche active et les caissons d'isolation implantés dans le substrat. Dans ce type d'architecture, la tension de seuil du transistor reste limitée. Il n'est pas possible d'effectuer une programmation MLC de cellules mémoire via cette architecture.

Il existe donc un besoin consistant à augmenter le courant passant tout en limitant les fuites de courant, de façon homogène pour l'ensemble des cellules mémoire, et permettre ainsi une programmation MLC et/ou une réduction de la taille des cellules mémoire.

Un objectif de la présente invention est de répondre à ce besoin, et de pallier au moins en partie les inconvénients mentionnés ci-dessus.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un premier aspect on prévoit un dispositif de pilotage de transistors selon la revendication indépendante de dispositif 1.

Ainsi, contrairement à l'architecture connue de transistors divulguée dans le document « Truly Innovative 28nm FDSOI Technology for Automotive Micro-Controller Applications embedding 16MB Phase Change Memory, F. Arnaud et al, IEDM18-424 (2018) », le dispositif selon la présente invention ne comprend que des transistors présentant un seul et même type de conductivité, typiquement une conductivité de type N. Cela permet d'augmenter les performances de l'ensemble des transistors en appliquant par exemple une seule première tension de polarisation en configuration « polarisation arrière directe » FBB via le circuit de polarisation. Au contraire, dans l'architecture connue comprenant des transistors complémentaires de type N et de type P, en polarisant en FBB l'ensemble des transistors avec un seul potentiel, certains seront accélérés et d'autres ralentis, ce qui limite le gain en performance global. Pour pallier en partie cet inconvénient, une solution proposée par le document « Truly Innovative 28nm FDSOI Technology for Automotive Micro-Controller Applications embedding 16MB Phase Change Memory, F. Arnaud et al, IEDM18-424 (2018) » consiste à recourir à des transistors et des caissons associés à ces transistors présentant un même type de conductivité, selon une architecture connue sous la dénomination « flip well ». Au contraire, dans le dispositif selon la présente invention, les transistors et leurs caissons associés présentent deux types de conductivité différents.

Le dispositif selon la présente invention permet également de limiter les fuites de courant de l'ensemble des transistors en appliquant une première tension de polarisation en configuration « polarisation arrière inverse » RBB via le circuit de polarisation.

Ainsi, le dispositif selon la présente invention permet d'obtenir une bonne homogénéité des performances des transistors. Il permet un fonctionnement des transistors en FBB ou en RBB avec une seule et même architecture, en fonction de la première tension de polarisation appliquée. Selon un exemple particulier, pour le pilotage de mémoires de type RRAM, le dispositif permet d'utiliser uniquement des transistors de sélection de type N, typiquement des transistors NMOS. Le dispositif permet également d'appliquer une polarisation FBB ou RBB comme on le souhaite, sans qu'il soit nécessaire de tenir compte de la présence de transistors PMOS comme dans l'art antérieur.

L'utilisation d'au moins un deuxième caisson pilotable en tension permet une isolation dynamique des premiers caissons entre eux. La plage de valeurs possibles pour la première tension de polarisation BB peut ainsi être étendue. Cela permet *in fine* de modifier plus fortement ou plus significativement les tensions de seuil des transistors. Dans le cas d'une diminution des tensions de seuil, les performances de ces transistors augmentent. La taille des transistors peut ainsi être réduite. Cela permet également de réduire les fuites en courant des transistors en BB natif, c'est-à-dire sans FBB. La consommation statique du dispositif est ainsi réduite.

Typiquement, la variation de potentiel du deuxième caisson ne modifie pas la conductivité du ou des transistors se trouvant sur le ou les premiers caissons. Le deuxième caisson permet notamment d'isoler les premiers caissons entre eux et vis-à-vis du substrat. La variation du potentiel du deuxième caisson permet avantageusement de doubler le domaine de potentiel du premier caisson.

Selon un autre aspect on prévoit un procédé de pilotage du dispositif de pilotage de transistors comprenant :
A un premier temps t1 :
- Appliquer une première tension de polarisation V1 à au moins un premier caisson de la pluralité de premiers caissons,
- Appliquer une deuxième tension de polarisation V2 à l'au moins un deuxième caisson entourant ledit au moins un premier caisson.

Lesdites applications des première et deuxième tensions V1, V2 sont telles qu'il n'y a pas de conduction électrique entre lesdits au moins un premier et deuxième caissons.

A un deuxième temps t2 :
- Appliquer une troisième tension de polarisation V3 à au moins un premier caisson (21) de la pluralité de premiers caissons,
- Appliquer une quatrième tension de polarisation V4 à l'au moins un deuxième caisson (22) entourant ledit au moins un premier caisson (21), lesdites troisième et quatrième tensions V3, V4 étant différentes de V1 et/ou de V2.

Le deuxième caisson joue ainsi le rôle d'isolation électrique entre les premiers caissons.

Cette isolation dynamique des premiers caissons entre eux, pilotée via le circuit de polarisation, permet avantageusement d'étendre la plage de valeurs possibles pour la première tension de polarisation BB. Cette plage de valeurs étendue permet typiquement d'envisager une programmation MLC lorsque les transistors sont des transistors de sélection associés à des éléments résistifs et formant avec lesdits éléments résistifs des cellules mémoire 1T1R. Contrairement à l'art antérieur, il est possible d'appliquer différents potentiels électriques aux premier et deuxième caissons du dispositif selon l'invention. Les tensions de polarisation appliquées aux premier et deuxième caissons peuvent varier dans le temps. Cette polarisation dynamique des premier et deuxième caissons permet d'envisager une programmation multiniveaux MLC. Selon un aspect, le dispositif permet d'associer un circuit de type FDSOI et des mémoires de type RRAM. Cela permet d'améliorer à la fois la programmation et les performances des mémoires de type RRAM (baisse de la consommation, accès au multi niveaux MLC ...).

Les autres objets, caractéristiques et avantages de la présente invention apparaîtront à l'examen de la description suivante et des dessins d'accompagnement. Il est entendu que d'autres avantages peuvent être incorporés. En particulier, certaines caractéristiques et certains avantages du dispositif de pilotage peuvent s'appliquer *mutatis mutandis* au procédé de pilotage de ce dispositif, et réciproquement.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1 illustre schématiquement en coupe transverse un dispositif de pilotage de transistors, selon un mode de réalisation de la présente invention.
La figure 2 illustre schématiquement en vue de dessus un dispositif de pilotage de transistors, selon un mode de réalisation de la présente invention.
La figure 3 illustre schématiquement en vue de dessus un dispositif de pilotage de transistors, selon un autre mode de réalisation de la présente invention.
La figure 4 illustre un schéma électrique d'une cellule mémoire, selon un mode de réalisation de la présente invention.
La figure 5 est un graphe illustrant différents niveaux de résistance du transistor (lorsqu'il est passant) obtenus dans le cadre d'une programmation MLC, selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches et portions, et les dimensions des motifs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, l'au moins un deuxième caisson comprend une pluralité de deuxièmes caissons séparés les uns des autres par le substrat, chaque deuxième caisson étant associé à, et disposé sous et autour d'un premier caisson de la pluralité de premiers caissons.

Selon un exemple, les transistors sont séparés les uns des autres par des tranchées d'isolation d'un seul type, typiquement des tranchées d'isolation peu profondes connues sous l'acronyme STI (signifiant « Shallow Trench Isolation »). Cela permet de simplifier la conception du dispositif, par rapport à un dispositif utilisant deux types de tranchées d'isolation, typiquement des tranchées d'isolation peu profondes STI et des tranchées d'isolation profondes connues sous l'acronyme DTI (signifiant « Deep Trench Isolation »).

Selon un exemple, les transistors sont des transistors de sélection, le dispositif comprenant en outre un élément résistif associé à chaque transistor de sélection et formant avec ledit transistor de sélection une cellule mémoire (1T1R).

Selon un exemple, tous les transistors de la pluralité de transistors sont des transistors MOS.

Selon un exemple, le deuxième type de conductivité est de type N. Les transistors de sélection sont ainsi de préférence des transistors NMOS.

Selon un exemple, tous les transistors sont des transistors MOS de type N, et la deuxième tension de polarisation V2 est comprise entre 0V et 6V.

Selon un exemple, la première tension de polarisation V1 est comprise entre -6V et +6V.

Selon un exemple, la deuxième tension de polarisation V2 est supérieure ou égale à la première tension de polarisation V1.

Selon un exemple, la première tension de polarisation V1 est telle que V2 - 6 ≤ V1 ≤ V2.

Selon un exemple, les transistors sont des transistors de sélection, le dispositif comprenant en outre un élément résistif associé à chaque transistor de sélection et formant avec ledit transistor de sélection une cellule mémoire (1T1R), le procédé comprenant en outre :
- Appliquer une tension de commande fixe à certains au moins des transistors de sélection, de façon à sélectionner certaines cellules mémoire associées auxdits transistors de sélection, et
- Faire varier la première tension de polarisation V1 de certains premiers caissons sous-jacents auxdites cellules mémoire sélectionnées, selon au moins trois valeurs de polarisation distinctes de sorte à créer au moins trois niveaux distincts de résistance du transistor de sélection pour lesdites cellules mémoire sélectionnées.

Selon un exemple, les transistors sont des transistors de sélection, le dispositif comprenant en outre un élément résistif associé à chaque transistor de sélection et formant avec ledit transistor de sélection une cellule mémoire (1T1R), le procédé comprenant en outre :
- Fixer la deuxième tension de polarisation V2 de l'au moins un deuxième caisson,
- Faire varier la première tension de polarisation V1 de certains premiers caissons sous-jacents aux transistors de sélection, selon au moins trois valeurs de polarisation distinctes de sorte à créer au moins trois niveaux distincts de résistance du transistor de sélection pour les cellules mémoire associées auxdits premiers caissons. La tension de polarisation V2 prend typiquement une valeur fixe, par exemple 0V, 3V, 6V, pendant un temps correspondant typiquement à la durée d'une opération élémentaire de programmation (par exemple le codage d'un bit). Cette valeur peut ensuite évoluer vers une autre valeur fixe, pour une autre opération élémentaire de programmation par exemple.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants. Ainsi, une couche à base de silicium s'entend par exemple d'une couche Si, Si dopé n, Si dopé p, SiGe.

Plusieurs modes de réalisation de l'invention mettant en œuvre des étapes successives du procédé de pilotage sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent », « intercalé » se réfèrent à des positions prises selon la direction z.

Les termes « vertical », « verticalement » se réfèrent à une direction selon z. Les termes « horizontal », « horizontalement », « latéral », « latéralement » se réfèrent à une direction dans le plan xy. Sauf mention explicite, l'épaisseur, la hauteur et la profondeur sont mesurées selon z.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Dans les exemples de réalisation ci-après, le dispositif de pilotage et le procédé de pilotage sont illustrés en particulier pour le pilotage de cellules mémoire de type 1T1R, comprenant typiquement un transistor et un élément résistif en série. L'invention n'est pas limitée aux cellules mémoire. Tout dispositif électronique à base de transistors d'un même type peut être mis en œuvre dans le dispositif de pilotage et/ou le procédé de pilotage selon la présente invention.

Dans les exemples de réalisation ci-après, le ou les premiers caissons sont de préférence des PWell. Le ou les deuxièmes caissons sont de préférence des Deep NWell et/ou NWell. Le substrat est de préférence de type P (Psub). Les transistors sont de préférence des NMOS. Il est entendu que les types de conductivité peuvent être inversés relativement les uns par rapport aux autres, selon un autre mode de réalisation de la présente invention.

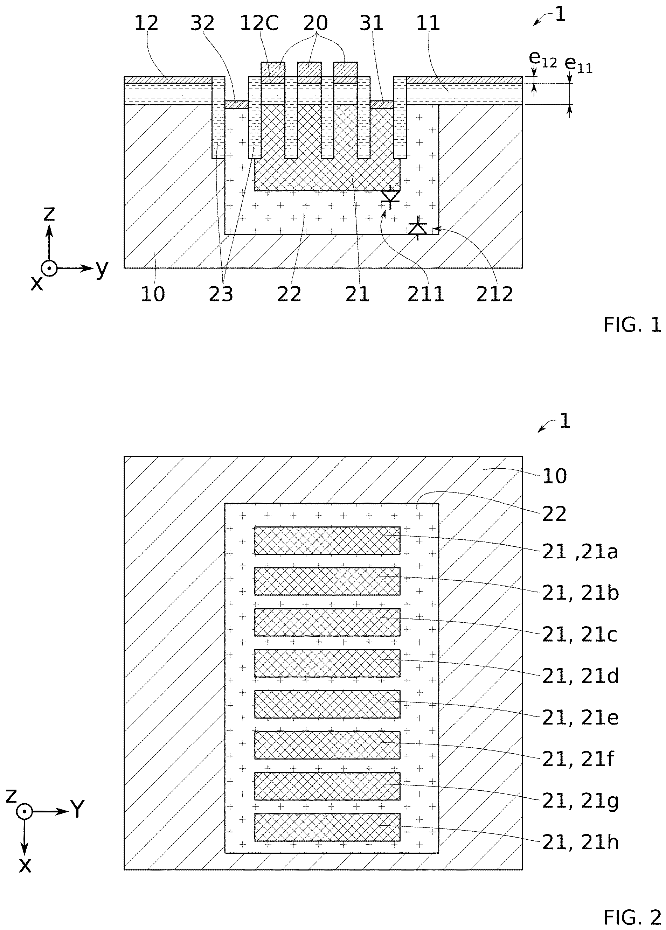

La figure 1 illustre un mode de réalisation du dispositif de pilotage de transistors.

Les transistors 20 sont ici typiquement des transistors MOS de type FDSOI à grille arrière, aussi appelés transistors à corps et oxyde enterré ultraminces ou UTBB (pour « Ultra Thin Body and BOX » en anglais). Ce type de transistor MOS est fabriqué à partir d'un substrat SOI comprenant successivement selon z un substrat 10 en silicium, une couche 11 électriquement isolante dite enterrée, généralement une couche d'oxyde (ou couche BOX, pour « buried oxide layer » en anglais), et une couche mince 12 en silicium monocristallin, aussi appelé couche active. La particularité du transistor UTBB FDSOI est que la couche 11 BOX est extrêmement mince, typiquement d'épaisseur e₁₁ inférieure à 30 nm, ce qui permet d'appliquer une polarisation en face arrière du transistor 20. L'épaisseur e₁₂ de la couche mince 12 en silicium monocristallin est typiquement inférieure à 10 nm.

Les transistors 20 présentent un canal 12c formé dans la couche active 12, sous la grille des transistors 20. Ce canal 12c est configuré pour fonctionner selon un mode dit « complétement déplété », à l'état bloqué du transistor. La couche active 12 est typiquement intentionnellement non-dopée.

Les transistors 20 du dispositif 1 présentent tous le même type de conductivité, de préférence une conductivité de type N (les porteurs de charge majoritaires sont des électrons).

Le dispositif 1 comprend également au moins un premier caisson 21 présentant un type de conductivité opposé au type de conductivité des transistors 20. Dans cet exemple, le caisson 21 est de type P. Un tel caisson de type P peut être dénommé « PWell » selon la terminologie usuelle. Ce premier caisson 21 permet typiquement d'appliquer une polarisation V1 en face arrière du ou des transistors 20. Cette polarisation V1 permet d'abaisser ou d'augmenter la tension de seuil des transistors 20, qui peuvent alors délivrer respectivement plus ou moins de courant. Il est en général intéressant que le transistor délivre plus de courant à l'état passant, et moins de courant de fuite (dans l'état bloqué).

Le dispositif 1 comprend un circuit de polarisation configuré pour appliquer cette première tension de polarisation V1 au premier caisson 21, par l'intermédiaire d'un premier contact 31.

Afin d'augmenter la plage de tension de polarisation V1, le dispositif 1 comprend un deuxième caisson 22 entourant le premier caisson V1. Le deuxième caisson 22 s'étend typiquement sous le premier caisson 21, et borde latéralement le premier caisson 21. Le deuxième caisson 22 est configuré pour isoler électriquement le premier caisson 21 vis-à-vis du substrat 10. Le deuxième caisson 22 présente un type de conductivité opposé au type de conductivité du premier caisson 21. Dans cet exemple, le caisson 22 est de type N, comme les transistors 20. Un tel caisson 22 de type N peut comprendre une partie s'étendant sous le premier caisson 21 dénommée « Deep NWell » selon la terminologie usuelle, et une partie entourant latéralement le premier caisson 21 dénommée « NWell ». La partie Deep NWell du caisson 22 permet typiquement d'assurer une isolation en profondeur du premier caisson 21, typiquement vis-à-vis du substrat 10. La partie NWell du caisson 22 permet typiquement d'assurer une isolation latérale du premier caisson 21, typiquement vis-à-vis d'un autre premier caisson 21 adjacent. Le deuxième caisson 22 est typiquement formé par un NWell et un Deep NWell. Dans la suite, le deuxième caisson 22 est indifféremment nommé « NWell » ou « Deep NWell », sans que cela limite nécessairement à l'une ou l'autre des parties dudit caisson.

Une première diode 211 PN est ainsi formée entre le premier caisson 21 et le deuxième caisson 22. Une deuxième diode 212 PN est ainsi formée entre le substrat 10 et le deuxième caisson 22.

Avantageusement, une deuxième tension de polarisation V2 peut être appliquée à ce deuxième caisson 22 par l'intermédiaire d'un deuxième contact 32 du circuit de polarisation. Cette deuxième tension de polarisation V2 est typiquement comprise entre 0V et 6V, ce qui permet de conserver la diode PN 212 dans l'état bloquant. Pour une diode PN 212 à base de silicium, le courant augmente significativement au-delà de 6V (ou en-dessous de -6V pour une diode polarisée en inverse), selon une caractéristique typique de diode Zener. Le substrat 10 de type P est typiquement polarisé à 0V.

La plage de tension de polarisation V1 permettant de conserver la diode PN 211 dans l'état bloquant est avantageusement augmentée en faisant varier la deuxième tension de polarisation V2. Pour des diodes 211, 212 sensiblement de même nature, la plage de tension de polarisation V1 est typiquement comprise entre -6V et +6V. Par exemple, pour V2 = 0V, la tension de polarisation V1 peut être comprise entre -6V et 0V. Cela correspond à une polarisation RBB des transistors NMOS 20. Pour V2 = 3V, la tension de polarisation V1 peut être comprise entre -3V et +3V. Pour V2 = 6V, la tension de polarisation V1 peut être comprise entre 0V et +6V. Cela correspond à une polarisation FBB des transistors NMOS 20. La plage de tension de polarisation V1 permettant de polariser en face arrière (BB) les transistors NMOS 20 est ainsi sensiblement doublée par l'ajout du Deep NWell 22 piloté en tension V2.

Le pilotage du deuxième caisson 22 est de préférence effectué de façon à conserver l'état bloquant des diodes 211, 212. Selon une possibilité, les tensions de polarisation V1, V2 sont appliquées via le circuit de polarisation telles que V1 ≤ V2.

Comme illustré à la figure 1, le dispositif 1 peut également comprendre des tranchées d'isolation 23 de part et d'autre des transistors 20 et des contacts 31, 32. Ces tranchées d'isolation 23 sont de préférence des tranchées d'isolation peu profondes appelées STI (pour « Shallow Trench Isolation » en anglais). De façon préférée, le dispositif 1 comprend uniquement des STI 23 entre les transistors 20 et les contacts 31, 32. En particulier et de façon avantageuse, le dispositif 1 ne nécessite pas de recourir à d'autres types de tranchées d'isolation, notamment à des tranchées d'isolation profondes appelées DTI (pour « Deep Trench Isolation » en anglais), pour étendre la plage de tension de polarisation V1 (polarisation BB). La technologie d'isolation par tranchées est ainsi simplifiée, et le coût associé reste faible en regard des technologies recourant à deux profondeurs de STI et/ou DTI.

La figure 2 illustre un mode de réalisation dans lequel huit premiers caissons 21a, 21b, 21c, 21d, 21e, 21f, 21g, 21h sont isolés les uns des autres par un deuxième caisson 22. Les premiers caissons 21a, 21b, 21c, 21d, 21e, 21f, 21g, 21h sont de préférence des PWell. Le deuxième caisson 22 est de préférence un Deep NWell. Le substrat 10 est de préférence de type P.

Pour une application de type RRAM ou OxRAM, chacun des huit premiers caissons peut comprendre une pluralité de cellules mémoire agencées sous forme de lignes. Chaque premier caisson comprend par exemple 8 lignes.

Chaque premier caisson peut être polarisé séparément des autres premiers caissons, via un circuit de polarisation dédié. Ainsi, un premier caisson 21 polarisé de façon à appliquer une polarisation arrière FBB aux transistors de sélection correspond typiquement à une opération de programmation des cellules mémoire (écriture ou effacement, SET/RESET). Les cellules mémoire formées sur ce premier caisson sont dites « sélectionnées ».

Les cellules mémoire formées sur un premier caisson 21 polarisé de façon à appliquer une polarisation arrière RBB aux transistors de sélection, sont typiquement « non sélectionnées », ou sélectionnées en lecture uniquement.

Il est ainsi possible de programmer les cellules mémoire des lignes formées sur le caisson 21a, en configuration FBB sur une plage de valeurs V1, V2 étendue, tout en maintenant les cellules mémoire des lignes formées sur les caissons 21b, 21c, 21d, 21e, 21f, 21g, 21h en configuration RBB sur une plage de valeurs V1, V2 étendue.

Cela permet par exemple de réduire la tension de seuil des transistors de sélection (connexion wordline) pour l'écriture ou l'effacement, en configuration FBB. La tension de seuil des transistors de sélection (connexion wordline) pour la lecture peut également être réduite, en configuration RBB. La consommation statique des lignes non sélectionnées peut également être réduite, en configuration RBB.

Les plages de valeurs étendues en RBB (-6V à 0V) et en FBB (0V à +6V) permettent avantageusement de lire et d'écrire plusieurs bits d'information au sein d'une cellule mémoire, comme décrit plus en détail dans la suite.

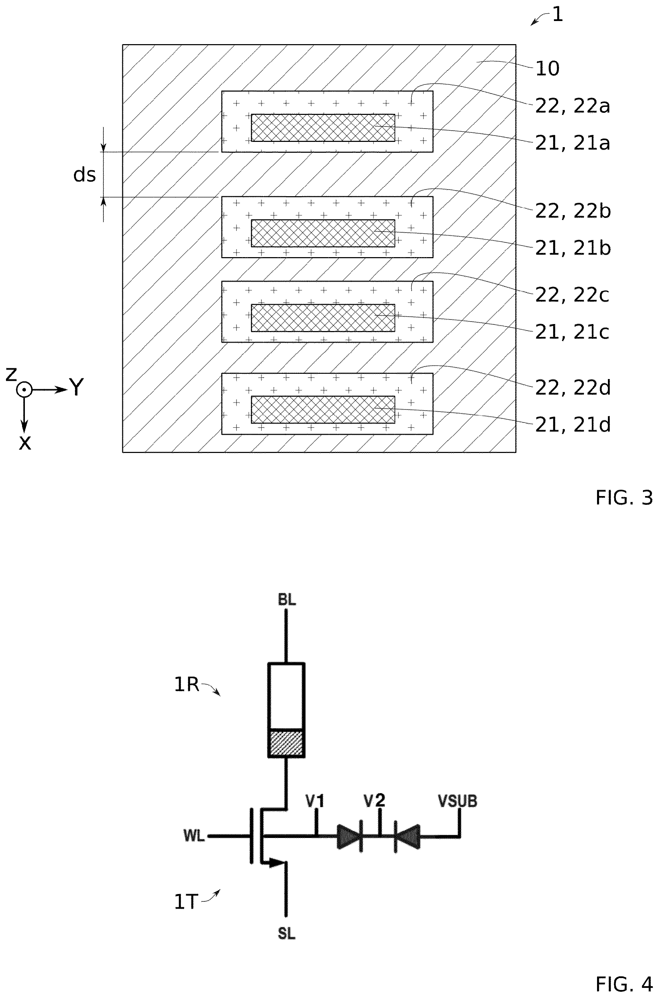

La figure 3 illustre un autre mode de réalisation dans lequel les premiers caissons 21, 21a, 21b, 21c, 21d, sont répartis dans différents deuxièmes caissons 22, 22a, 22b, 22c, 22d. Dans cet exemple, chaque premier caisson 21 est associé à un deuxième caisson 22. D'autres configurations sont envisageables, par exemple quatre premiers caissons 21 répartis au sein de deux deuxièmes caissons 22.

Les deuxièmes caissons 22a, 22b, 22c, 22d sont séparés et isolés les uns des autres par le substrat 10. La distance de séparation ds entre deux deuxièmes caissons 22a, 22b adjacents est de l'ordre de quelques micromètres, par exemple 3 µm. Cela permet de polariser indépendamment les deuxièmes caissons 22. Les possibilités d'appliquer différentes polarisations FBB et RBB sont accrues. Ainsi, par exemple, le premier caisson 21a PWell est polarisé à -6V et le deuxième caisson 22a Deep NWell est polarisé à 0V. Cela permet de générer une polarisation RBB limitant ou supprimant les fuites de courant. Les cellules mémoires associées au caisson 21a ne sont pas sélectionnées. Le premier caisson 21b PWell est par exemple polarisé à +6V et le deuxième caisson 22b Deep NWell est polarisé à +6V. Cela permet de générer une polarisation FBB réduisant la tension de seuil des transistors de sélection, pour des opérations d'écriture ou d'effacement par exemple. Les tensions de polarisation V2 sont ainsi appliquées indépendamment les unes des autres via le circuit de polarisation. La versatilité du dispositif 1 est augmentée. Les polarisations V1, V2 des premiers et deuxièmes caissons 21, 22 peuvent varier dynamiquement en fonction des accès mémoire par exemple. L'application des tensions de polarisation V1, V2 est typiquement pilotée par le circuit de polarisation du dispositif 1. Le nombre de configurations de polarisations RBB et/ou FBB des différentes cellules mémoire est ainsi augmenté. Les plages de valeurs étendues en RBB (-6V à 0V) et en FBB (0V à +6V) permettent également de mettre en œuvre une programmation MLC facilitée des cellules mémoire.

La figure 4 illustre un schéma électrique d'une cellule mémoire montée sur un premier caisson PWell isolé du substrat par un deuxième caisson Deep NWell, selon un principe de l'invention.

Avantageusement, la programmation MLC des cellules mémoire peut être implémentée en contrôlant la polarisation arrière (BB) par la tension de polarisation V1, dont la plage de valeurs est étendue en faisant varier V2. En particulier, le contrôle de la polarisation arrière BB permet de contrôler la tension de seuil du transistor et donc la résistance R entre la source et le drain du transistor (1T) qui joue le rôle d'un limiteur de courant passant, notamment dans une opération SET de mémoire. Si la résistance R du transistor est réduite, le courant passant augmente. Cela permet de renforcer l'opération de SET.

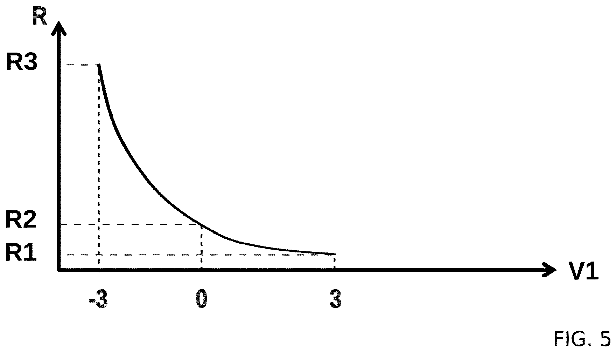

Comme illustré à la figure 5, la variation de tension de polarisation V1 (BB) introduit une variation de la résistance R du transistor et donc de l'élément résistif de la mémoire RRAM. Il est ainsi possible d'accéder à 3 niveaux ou plus de résistance RRAM codant chacun pour des bits d'information distincts. Dans l'exemple illustré, pour 3 valeurs de V1 comprises dans la plage de valeurs entre -3V et +3V, V2 étant fixée à +3V, 3 niveaux de résistance R1, R2, R3 sont obtenus. En étendant la plage de valeurs de V1, par exemple entre -6V et +6V, le nombre de niveaux de résistance permis augmente.

L'utilisation d'un double caisson PWell / Deep NWell pilotable en tension pour des transistors NMOS FDSOI permet avantageusement de modifier fortement les tensions de seuil de ces transistors. L'efficacité énergétique globale est améliorée. Un tel double caisson pilotable en tension permet également d'envisager l'implémentation de MLC pour des cellules mémoires à base d'un seul et même type de transistor. La surface occupée par ces cellules mémoire stockant chacune plus qu'un bit de donnée peut ainsi être significativement réduite.

L'invention n'est pas limitée aux modes de réalisation précédemment décrits.

## Revendications

1. Dispositif de pilotage de transistors (1) comprenant :
• Un substrat (10) à base d'un matériau semiconducteur, présentant un premier type de conductivité (P),
• Une couche isolante (11) à base d'un matériau diélectrique sur ledit substrat (10),
• Une couche (12) à base du matériau semiconducteur, dite couche active, située sur la couche isolante (11),
• Une pluralité de transistors (20) comprenant chacun un canal (12c) formé dans la couche active (12) et configuré pour être complétement déplété,
• Une pluralité de premiers caissons (21, 21a, 21b, 21c, 21d, 21e, 21f, 21g, 21h) formés dans le substrat (10) et présentant le premier type de conductivité (P), chaque premier caisson (21) étant associé à et disposé sous un groupe de transistors de la pluralité de transistors (20),
• Au moins un deuxième caisson (22, 22a, 22b, 22c, 22d) présentant un deuxième type de conductivité (N), formé dans le substrat (10) sous et autour des premiers caissons (21), de sorte à isoler les premiers caissons (21) entre eux et vis-à-vis du substrat (10), ledit au moins un deuxième caisson (22, 22a, 22b, 22c, 22d) comprenant un ou plusieurs premiers caissons (21) présentant chacun uniquement le premier type de conductivité (P),
• Un circuit de polarisation configuré pour appliquer au moins une première tension de polarisation V1 aux premiers caissons (21), et au moins une deuxième tension de polarisation V2 à l'au moins un deuxième caisson (22),
Tous les transistors (20) de la pluralité de transistors présentent le deuxième type de conductivité (N),
Le dispositif (1) étant **caractérisé en ce que** les premiers caissons (21) sont directement au contact de la couche isolante (11) et ne comprennent pas de régions de conductivité différente du premier type de conductivité (P), de sorte que le substrat (10) ne comprend pas de plan de masse au sein d'un premier caisson (21).

2. Dispositif (1) selon la revendication précédente dans lequel l'au moins un deuxième caisson (22) comprend une pluralité de deuxièmes caissons (22a, 22b, 22c, 22d) séparés les uns des autres par le substrat (10), chaque deuxième caisson (22, 22a, 22b, 22c, 22d) étant associé à et disposé sous et autour d'un premier caisson (21, 21a, 21b, 21c, 21d) de la pluralité de premiers caissons.

3. Dispositif (1) selon l'une quelconque des revendications précédentes dans lequel les transistors (20) sont séparés les uns des autres par des tranchées d'isolation (23) d'un seul type (STI).

4. Dispositif (1) selon la revendication précédente dans lequel les tranchées d'isolation (23) traversent complètement la couche active (12) et ne traversent pas complètement les premiers caissons (21) de la pluralité de premiers caissons (21, 21a, 21b, 21c, 21d, 21e, 21f, 21g, 21h).

5. Dispositif (1) selon l'une quelconque des revendications précédentes dans lequel les transistors (20) sont des transistors de sélection, le dispositif (1) comprenant en outre un élément résistif (1R) associé à chaque transistor de sélection et formant avec ledit transistor de sélection une cellule mémoire (1T1R).

6. Dispositif (1) selon l'une quelconque des revendications précédentes dans lequel tous les transistors (20) de la pluralité de transistors sont des transistors MOS et dans lequel le deuxième type de conductivité est de type N.

7. Procédé de pilotage d'un dispositif de pilotage de transistors (1) selon l'une quelconque des revendications précédentes comprenant :
A un premier temps t1 :
• Appliquer une première tension de polarisation V1 à au moins un premier caisson (21) de la pluralité de premiers caissons,
• Appliquer une deuxième tension de polarisation V2 à l'au moins un deuxième caisson (22) entourant ledit au moins un premier caisson (21),
Lesdites applications des première et deuxième tensions V1, V2 étant telles qu'il n'y a pas de conduction électrique entre lesdits au moins un premier et deuxième caissons (21, 22),
A un deuxième temps t2 :
• Appliquer une troisième tension de polarisation V3 à au moins un premier caisson (21) de la pluralité de premiers caissons,
• Appliquer une quatrième tension de polarisation V4 à l'au moins un deuxième caisson (22) entourant ledit au moins un premier caisson (21), lesdites troisième et quatrième tensions V3, V4 étant différentes de V1 et/ou de V2.

8. Procédé selon la revendication précédente dans lequel tous les transistors (20) sont des transistors MOS de type N, et dans lequel la deuxième tension de polarisation V2 est comprise entre 0V et 6V.

9. Procédé selon l'une quelconque des deux revendications précédentes dans lequel la première tension de polarisation V1 est comprise entre -6V et +6V.

10. Procédé selon l'une quelconque des trois revendications précédentes dans lequel la deuxième tension de polarisation V2 est supérieure ou égale à la première tension de polarisation V1.

11. Procédé selon l'une quelconque des revendications 7 à 10 dans lequel la première tension de polarisation V1 est telle que V2 - 6 ≤ V1 ≤ V2.

12. Procédé selon l'une quelconque des revendications 7 à 11, dans lequel les transistors (20) sont des transistors de sélection, le dispositif (1) comprenant en outre un élément résistif (1R) associé à chaque transistor de sélection et formant avec ledit transistor de sélection une cellule mémoire (1T1R), ledit procédé comprenant en outre :
• Appliquer une tension de commande fixe à certains au moins des transistors de sélection, de façon à sélectionner certaines cellules mémoire associées auxdits transistors de sélection, et
• Faire varier la première tension de polarisation V1 de certains premiers caissons (21) sous-jacents auxdites cellules mémoire sélectionnées, selon au moins trois valeurs de polarisation distinctes de sorte à créer au moins trois niveaux distincts de résistance du transistor de sélection (R1, R2, R3) pour lesdites cellules mémoire sélectionnées.

13. Procédé selon l'une quelconque des revendications 7 à 11, dans lequel les transistors (20) sont des transistors de sélection, le dispositif (1) comprenant en outre un élément résistif (1R) associé à chaque transistor de sélection et formant avec ledit transistor de sélection une cellule mémoire (1T1R), ledit procédé comprenant en outre :
• Fixer la deuxième tension de polarisation V2 de l'au moins un deuxième caisson (22),
• Faire varier la première tension de polarisation V1 de certains premiers caissons (21) sous-jacents aux transistors de sélection, selon au moins trois valeurs de polarisation distinctes de sorte à créer au moins trois niveaux distincts de résistance du transistor de sélection (R1, R2, R3) pour les cellules mémoire associées auxdits premiers caissons.

## Patentansprüche

1. Transistorenansteuerungsvorrichtung (1), die Folgendes umfasst:
• ein Substrat (10) auf Basis eines Halbleitermaterials, das einen ersten Leitfähigkeitstyp (P) aufweist,
• eine Isolierschicht (11) auf Basis eines dielektrischen Materials auf dem Substrat (10),
• eine Schicht (12) auf Basis des Halbleitermaterials, aktive Schicht genannt, die sich auf der Isolierschicht (11) befindet,
• eine Vielzahl von Transistoren (20), die jeweils einen Kanal (12c) umfassen, der in der aktiven Schicht (12) gebildet und dazu konfiguriert ist, vollständig verarmt zu sein,
• eine Vielzahl erster Vertiefungen (21, 21a, 21b, 21c, 21d, 21e, 21f, 21g, 21h), die in dem Substrat (10) gebildet sind und den ersten Leitfähigkeitstyp (P) aufweisen, wobei jede erste Vertiefung (21) einer Gruppe von Transistoren der Vielzahl von Transistoren (20) zugeordnet und darunter angeordnet ist,
• mindestens eine zweite Vertiefung (22, 22a, 22b, 22c, 22d), die einen zweiten Leitfähigkeitstyp (N) aufweist, der in dem Substrat (10) unter und um erste Vertiefungen (21) derart angeordnet ist, dass die ersten Vertiefungen (21) voneinander und gegenüber dem Substrat (10) isoliert sind, wobei die mindestens eine Vertiefung (22, 22a, 22b, 22c, 22d) eine oder mehrere erste Vertiefungen (21) aufweist, die jeweils nur den ersten Leitfähigkeitstyp (P) aufweisen,
• eine Polarisationsschaltung, die dazu konfiguriert ist, mindestens eine erste Polarisationsspannung V1 an die ersten Vertiefungen (21) und mindestens eine zweite Polarisationsspannung V2 an die mindestens eine zweite Vertiefung (22) anzulegen,
wobei alle Transistoren (20) der Vielzahl von Transistoren einen zweiten Leitfähigkeitstyp (N) aufweisen, wobei die Vorrichtung (1) **dadurch gekennzeichnet ist, dass** die ersten Vertiefungen(21) direkt in Kontakt mit der Isolierschicht (11) stehen und keine Bereiche unterschiedlicher Leitfähigkeit des ersten Leitfähigkeitstyps (P) derart umfassen, dass das Substrat (10) keine Masseebene innerhalb einer ersten Vertiefung (21) umfasst.

2. Vorrichtung (1) nach dem vorstehenden Anspruch, wobei die mindestens eine zweite Vertiefung (22) eine Vielzahl zweiter Vertiefungen (22a, 22b, 22c, 22d) umfasst, die voneinander durch das Substrat (10) getrennt sind, wobei jede zweite Vertiefung (22, 22a, 22b, 22c, 22d) einer ersten Vertiefung (21, 21a, 21b, 21c, 21d) der Vielzahl erster Vertiefungen zugeordnet und unter dieser und um diese angeordnet ist.

3. Vorrichtung (1) nach einem der vorstehenden Ansprüche, wobei die Transistoren (20) voneinander durch Isoliergräben (23) eines einzigen Typs (STI) getrennt sind.

4. Vorrichtung (1) nach dem vorstehenden Anspruch, wobei die Isoliergräben (23) die aktive Schicht (12) vollständig durchqueren und die ersten Vertiefungen (21) der Vielzahl erster Vertiefungen (21,21a, 21b, 21c, 21d, 21e, 21f, 21g, 21h) nicht vollständig durchqueren.

5. Vorrichtung (1) nach einem der vorstehenden Ansprüche, wobei die Transistoren (20) Auswahltransistoren sind, wobei die Vorrichtung (1) außerdem ein Widerstandselement (1R) umfasst, das jedem Auswahltransistor zugeordnet ist und mit dem Auswahltransistor eine Speicherzelle (1T1R) bildet.

6. Vorrichtung (1) nach einem der vorstehenden Ansprüche, wobei alle Transistoren (20) der Vielzahl von Transistoren MOS-Transistoren sind, und wobei der zweite Leitfähigkeitstyp vom N-Typ ist.

7. Ansteuerverfahren einer Transistorenansteuerungsvorrichtung (1) nach einem der vorstehenden Ansprüche, das Folgendes umfasst:
in einem ersten Zeitpunkt t1:
• Anlegen einer ersten Polarisationsspannung V1 an mindestens eine erste Vertiefung (21) der Vielzahl erster Vertiefungen,
• Anlegen einer zweiten Polarisationsspannung V2 an mindestens eine zweite Vertiefung (22), die die mindestens eine erste Vertiefung (21) umgibt,
wobei die Anlegungen der ersten und der zweiten Spannung V1, V2 derart sind, dass kein elektrisches Leiten zwischen der mindestens einen ersten und einen zweiten Vertiefungen (21, 22) besteht,
in einem zweiten Zeitpunkt t2:
• Anlegen einer dritten Polarisationsspannung V3 an mindestens eine erste Vertiefung (21) der Vielzahl erster Vertiefungen,
• Anlegen einer vierten Polarisationsspannung V4 an mindestens eine zweite Vertiefung (22), die die mindestens eine erste Vertiefung (21) umgibt, wobei die dritte und die vierte Spannung V3, V4 von V1 und/oder von V2 unterschiedlich sind.

8. Verfahren nach dem vorstehenden Anspruch, wobei alle Transistoren (20) MOS-Transistoren vom N-Typ sind, und wobei die zweite Polarisationsspannung V2 zwischen 0 V und 6 V liegt.

9. Verfahren nach einem der beiden vorstehenden Ansprüche, wobei die erste Polarisationsspannung V1 zwischen -6 V und +6 V liegt.

10. Verfahren nach einem der drei vorstehenden Ansprüche, wobei die zweite Polarisationsspannung V2 größer oder gleich der ersten Polarisationsspannung V1 ist.

11. Verfahren nach einem der Ansprüche 7 bis 10, wobei die erste Polarisationsspannung V1 derart ist, dass V2 - 6 ≤ V1 ≤ V2 ist.

12. Verfahren nach einem der Ansprüche 7 bis 11, wobei die Transistoren (20) Auswahltransistoren sind, die Vorrichtung (1) außerdem ein Widerstandselement (1R) umfasst, das jedem Auswahltransistor zugeordnet ist und mit dem Auswahltransistor eine Speicherzelle (1T1R) bildet, wobei das Verfahren außerdem Folgendes umfasst:
• Anlegen einer fixen Steuerspannung an mindestens bestimmte der Auswahltransistoren derart, dass bestimmte Speicherzellen, die den Auswahltransistoren zugeordnet sind, ausgewählt werden, und
• Variieren der ersten Polarisationsspannung V1 bestimmter erster Vertiefungen (21) unter den ausgewählten Speicherzellen gemäß mindestens drei getrennten Polarisationswerten derart, dass mindestens drei getrennte Widerstandsebenen des Auswahlwiderstands (R1, R2, R3) für die ausgewählten Speicherzellen geschaffen werden.

13. Verfahren nach einem der Ansprüche 7 bis 11, wobei die Transistoren (20) Auswahltransistoren sind, die Vorrichtung (1) außerdem ein Widerstandselement (1R) umfasst, das jedem Auswahltransistor zugeordnet ist und mit dem Auswahltransistor eine Speicherzelle (1T1R) bildet, wobei das Verfahren außerdem Folgendes umfasst:
• Festlegen der zweiten Polarisationsspannung V2 der mindestens einen zweiten Vertiefung (22),
• Variieren der ersten Polarisationsspannung V1 bestimmter Vertiefungen (21) unter den Auswahltransistoren gemäß mindestens drei getrennten Polarisationswerten derart, dass mindestens drei getrennte Widerstandsebenen des Auswahltransistors (R1, R2, R3) für die Speicherzellen, die den ersten Vertiefungen zugeordnet sind, geschaffen werden.

## Claims

1. Transistor driving device (1) comprising:
- A substrate (10) with the basis of a semiconductive material (10), having a first type of conductivity (P),
- An insulating layer (11) with the basis of a dielectric material on said substrate (10),
- A semiconductive material-based layer (12), called active layer, located on the insulating layer (11),
- A plurality of transistors (20), each comprising a channel (12c) formed in the active layer (12) and configured to be completely depleted,
- A plurality of first chambers (21, 21a, 21b, 21c, 21d, 21e, 21f, 21g, 21h) formed in the substrate (10) and having the first type of conductivity (P), each first chamber (21) being associated with and disposed under a group of transistors of the plurality of transistors (20),
- At least one second chamber (22, 22a, 22b, 22c, 22d) having a second type of conductivity (N), formed in the substrate (10) under and around the first chambers (21), so as to insulate the first chambers (21) from one another and regarding the substrate (10), said at least one second chamber (22, 22a, 22b, 22c, 22d) comprising one or more first chambers (21), each only having the first type of conductivity (P),
- A bias circuit, configured to apply at least one first bias voltage V1 to the first chambers (21), and at least one second bias voltage V2 to the at least one second chamber (22),
All the transistors (20) of the plurality of transistors having the second type of conductivity (N), the device (1) being **characterised in that** the first chambers (21) are directly in contact with the insulating layer (11) and do not comprise conductivity regions which are different from the first type of conductivity (P), such that the substrate (10) does not comprise a ground plane within a first chamber (21).

2. Device (1) according to the preceding claim, wherein the at least one second chamber (22) comprises a plurality of second chambers (22a, 22b, 22c, 22d) separated from one another by the substrate (10), each second chamber (22, 22a, 22b, 22c, 22d) being associated with and disposed under and around a first chamber (21, 21a, 21b, 21c, 21d) of the plurality of first chambers.

3. Device (1) according to any one of the preceding claims, wherein the transistors (20) are separated from one another by insulating trenches (23) of one single type (STI).

4. Device (1) according to the preceding claim, wherein the insulating trenches (23) completely pass through the active layer (12) and do not completely pass through the first chambers (21) of the plurality of first chambers (21, 21a, 21b, 21c, 21d, 21e, 21f, 21g, 21h).

5. Device (1) according to any one of the preceding claims, wherein the transistors (20) are selection transistors, the device (1) further comprising a resistive element (1R) associated with each selection transistor and forming a memory cell (1T1R) with said selection transistor.

6. Device (1) according to any one of the preceding claims, wherein all the transistors (20) of the plurality of transistors are MOS transistors, and wherein the second type of conductivity is of the N type.

7. Method for driving a transistor driving device (1) according to any one of the preceding claims, comprising:
At a first time t1:
- Applying a first bias voltage V1 to at least one first chamber (21) of the plurality of first chambers,
- Applying a second bias voltage V2 to the at least one second chamber (22) surrounding said at least one first chamber (21),
Said applications of the first and second voltages V1, V2 being such that there is no electrical conduction between said at least one first and second chambers (21, 22),
At a second time t2:
- Applying a third bias voltage V3 to at least one first chamber (21) of the plurality of first chambers,
- Applying a fourth bias voltage V4 to the at least one second chamber (22) surrounding said at least one first chamber (21), said third and fourth voltages V3, V4 being different from V1 and/or from V2.

8. Method according to the preceding claim, wherein all the transistors (20) are N-type MOS transistors, and wherein the second bias voltage V2 is between 0V and 6V.

9. Method according to any one of the two preceding claims, wherein the first bias voltage V1 is between -6V and +6V.

10. Method according to any one of the three preceding claims, wherein the second bias voltage V2 is greater than or equal to the first bias voltage V1.

11. Method according to any one of claims 7 to 10, wherein the first bias voltage V1 is such that V2 - 6 ≤ V1 ≤ V2.

12. Method according to any one of claims 7 to 11, wherein the transistors (20) are selection transistors, the device (1) further comprising a resistive element (1R) associated with each selection transistor, and forming a memory cell (1T1R) with said selection transistor, said method further comprising:
- Applying a fixed control voltage to at least some of the selection transistors, so as to select certain memory cells associated with said selection transistors, and
- Making the first bias voltage V1 of some first chambers (21) underlying said selected memory cells vary, according to at least three distinct bias voltages, so as to create at least three distinct levels of resistance of the selection transistor (R1, R2, R3) for said selected memory cells.

13. Method according to any one of claims 7 to 11, wherein the transistors (20) are selection transistors, the device (1) further comprising a resistive element (1R) associated with each selection transistor, and forming a memory cell (1T1R) with said selection transistor, said method further comprising:
- Fixing the second bias voltage V2 of the at least one second chamber (22),
- Making the first bias voltage V1 of some first chambers (21) underlying the selection transistors vary, according to at least three distinct bias values, so as to create at least three distinct levels of resistance of the selection transistor (R1, R2, R3) for the memory cells associated with said first chambers.
